# FASCICULE DE BREVET EUROPEEN

(11) **EP 4 683 463 B1**
(45) Date de publication et mention de la délivrance du brevet: **01.07.2026**
(21) Numéro de dépôt: 25184393.4
(22) Date de dépôt: 23.06.2025
(51) Int. Cl.: H10F 19/80, H10F 71/00, B26D 5/00, B32B 43/00, B09B 3/30

(54) **PROCÉDÉ DE TRAITEMENT D'UN MODULE PHOTOVOLTAÏQUE POUR RETRAIT DES RUBANS D'INTERCONNEXION**
VERFAHREN ZUR VERARBEITUNG EINES PHOTOVOLTAIKMODULS ZUR ENTFERNUNG VON VERBINDUNGSBÄNDERN
METHOD OF PROCESSING A PHOTOVOLTAIC MODULE FOR REMOVAL OF INTERCONNECT RIBBONS

(30) Priorité: 16.07.2024 FR 2407762
(43) Date de publication de la demande: 21.01.2026
(73) Titulaire: Commissariat à l'Energie Atomique et aux Energies Alternatives, 75015 Paris (FR)
(72) Inventeur: RIVA, Roland, 38054 Grenoble cedex 09 (FR); COUSTIER, Fabrice, 38054 Grenoble cedex 09 (FR); DE BETTIGNIES, Rémi, 38054 Grenoble cedex 09 (FR); LANDA PLIQUET, Margot, 38054 Grenoble cedex 09 (FR)
(74) Mandataire: INNOV-GROUP

(56) Documents cités:
- EP-A1- 4 159 397
- US-A1- 2024 123 479

## Description

### Domaine technique de l'invention

La présente invention se rapporte à un procédé de traitement d'un module photovoltaïque, mis en œuvre plus particulièrement pour le retrait des rubans d'interconnexion du module photovoltaïque.

### Etat de la technique

Un module photovoltaïque comporte des cellules photovoltaïques destinées à convertir une énergie solaire en une énergie électrique.

Un tel module photovoltaïque comporte de nombreux matériaux intéressants à récupérer et à valoriser, lorsque le module est en fin de vie ou défaillant.

Classiquement, un module photovoltaïque se présente sous la forme d'un panneau composé par l'assemblage de trois couches principales superposées et fixées entre elles :
- Une première couche, dite couche arrière (appelée couramment "backsheet"), formant un premier élément de protection en face arrière ;
- Une deuxième couche, dite couche intermédiaire ; cette couche intermédiaire comporte les cellules photovoltaïques, la connectique électrique entre les cellules et une enveloppe d'encapsulation arrangée autour des cellules photovoltaïques ;
- Une troisième couche, dite couche avant, formant un deuxième élément de protection en face avant ; cette couche avant est souvent en verre ou réalisée dans un polymère transparent pour être traversée par les rayons lumineux captés ;

En vue du recyclage d'un module photovoltaïque, différentes solutions ont déjà été envisagées. Une première méthode consiste à broyer le module dans sa totalité, puis de lui faire subir divers traitements mécaniques, thermiques et/ou chimiques afin de séparer les matériaux qui entrent dans sa composition, comme le verre, l'argent, le cuivre, le silicium... Cette première méthode est cependant coûteuse en énergie et peu respectueuse de l'environnement.

La demande de brevet WO2019/043329A1 propose une méthode de désassemblage d'un module photovoltaïque, qui consiste à retirer chaque couche du module pour la séparer, en la découpant avec un fil abrasif. Chaque couche retirée peut ensuite être traitée de manière séparée en vue de récupérer les matériaux d'intérêt. Cette dernière méthode présente certains inconvénients. Elle nécessite plusieurs postes de traitement distincts, d'abord pour la découpe, puis pour le broyage de chaque couche retirée.

La demande de brevet EP3352227A1 et la demande de brevet US2018/133720A1 décrivent des solutions de désassemblage de module photovoltaïque.

La demande de brevet EP4159397A1 décrit pour sa part le retrait par ponçage du premier élément de protection situé en face arrière et un usinage sélectif de la couche intermédiaire, réalisé par fraisage.

Dans la couche intermédiaire, les cellules photovoltaïques sont connectées électriquement entre elles de manière à former plusieurs chaînes de cellules photovoltaïques. Dans chaque chaîne, les cellules sont connectées entre elles à l'aide de fils ou d'éléments de connexion fins. Les chaînes de cellules photovoltaïques sont également connectées électriquement entre elles à l'aide de rubans d'interconnexion plus épais et localisés en bout de chaîne, ces rubans s'étendant généralement à proximité des bords du module photovoltaïque.

Le traitement pour recyclage de la couche intermédiaire peut être réalisé par usinage, en utilisant par exemple une bande de ponçage. La bande de ponçage est appliquée contre la surface de la couche à traite suivant une direction normale à cette surface, alors que le module est mis en mouvement par un convoyeur suivant une direction longitudinale. Dans le cas du ponçage de la couche intermédiaire, on a constaté que les rubans d'interconnexion sont souvent arrachés, venant s'accumuler au voisinage de la bande de ponçage pouvant entraîner des dommages sur la bande de ponçage et nécessitant à terme un nettoyage approfondi de l'équipement, particulièrement long et coûteux.

Le but de l'invention est donc de proposer une solution permettant de faire en sorte que les rubans d'interconnexion employés pour connecter les chaînes de cellules entre elles ne viennent pas perturber un usinage de la couche intermédiaire. La solution proposée permet un retrait préalable de ces rubans d'interconnexion.

### Exposé de l'invention

Ce but est atteint par un procédé de traitement d'un module photovoltaïque, ledit module photovoltaïque comprenant notamment une couche dite intermédiaire, cette couche intermédiaire comportant une enveloppe d'encapsulation dans laquelle sont placées des cellules photovoltaïques et au moins un ruban d'interconnexion, lesdites cellules photovoltaïques étant agencées en plusieurs chaînes, les chaînes étant connectées entre elles à l'aide dudit ruban d'interconnexion, ledit procédé comportant :
- Une étape de localisation du ruban d'interconnexion à l'intérieur de la couche intermédiaire,
- Une étape de détermination d'une zone de travail à usiner, ladite zone de travail étant délimitée pour inclure le ruban d'interconnexion et exclure toute cellule photovoltaïque,
- Une étape d'usinage localisée sur ladite zone de travail uniquement.

Selon une particularité, l'étape d'usinage est mise en œuvre par ponçage.

Selon une autre partoicularité, l'étape d'usinage est mise en œuvre en amenant un outil d'usinage en vis-à-vis de la zone de travail déterminé suivant un axe perpendiculaire au plan défini par la surface de la couche intermédiaire.

Selon une réalisation particulière, l'outil d'usinage est une bande de ponçage mise en mouvement autour d'un axe perpendiculaire à une direction suivant laquelle ledit ruban d'interconnexion est déployé.

Selon une autre réalisation particulière, l'outil d'usinage est une bande de ponçage mise en mouvement autour d'un axe parallèle à une direction suivant laquelle le ruban d'interconnexion est déployé.

Selon une réalisation particulière, l'étape de localisation du ruban d'interconnexion est mise en œuvre par capture optique de la couche intermédiaire.

Selon une autre réalisation particulière, l'étape de localisation du ruban d'interconnexion est mise en œuvre par capture d'images à l'aide d'une caméra orientée en direction de la couche intermédiaire.

Selon une autre particularité, la zone de travail déterminée est définie par un rectangle entourant en deux dimensions ledit ruban d'interconnexion.

Selon une autre particularité, la zone de travail comporte une troisième dimension, correspondant à la profondeur d'usinage.

L'invention concerne un système de traitement d'un module photovoltaïque, ledit module photovoltaïque comprenant notamment une couche dite intermédiaire, cette couche intermédiaire comportant une enveloppe d'encapsulation dans laquelle sont placées des cellules photovoltaïques et au moins un ruban d'interconnexion, lesdites cellules photovoltaïques étant agencées en plusieurs chaînes, les chaînes étant connectées entre elles à l'aide dudit ruban d'interconnexion, le système comportant une unité de traitement et des moyens d'analyse de la couche intermédiaire configurés pour générer des données à destination de l'unité de traitement, l'unité de traitement étant configurée pour localiser le ruban d'interconnexion à l'intérieur de la couche intermédiaire à partir des données reçues, l'unité de traitement étant configurée pour déterminer une zone de travail à usiner, ladite zone de travail étant délimitée pour inclure le ruban d'interconnexion et exclure toute cellule photovoltaïque, le système comportant des moyens d'usinage contrôlés par l'unité de traitement pour usiner ladite zone de travail uniquement.

ledit système comportant :
- Des moyens de localisation du ruban d'interconnexion à l'intérieur de la couche intermédiaire,
- Des moyens de détermination d'une zone de travail à usiner, ladite zone de travail étant délimitée pour inclure le ruban d'interconnexion et exclure toute cellule photovoltaïque,
- Des moyens d'usinage localisés sur ladite zone de travail uniquement.

Selon une particularité, les moyens d'usinage comportent un outil d'usinage formé d'un outil de ponçage.

Selon une autre particularité, les moyens d'usinage sont configurés pour amener un outil d'usinage en vis-à-vis de la zone de travail déterminé suivant un axe perpendiculaire au plan défini par la surface de la couche intermédiaire.

Selon une réalisation particulière, l'outil d'usinage est formé d'une bande de ponçage mise en mouvement autour d'un axe perpendiculaire à une direction suivant laquelle ledit ruban d'interconnexion est déployé.

Selon une autre réalisation particulière, l'outil d'usinage est formé d'une bande de ponçage mise en mouvement autour d'un axe parallèle à une direction suivant laquelle le ruban d'interconnexion est déployé.

Selon une réalisation particulière, les moyens d'analyse comportent des moyens de capture optique de la couche intermédiaire.

Selon une autre réalisation particulière, les moyens d'analyse comportent des moyens de capture d'images à l'aide d'une caméra orientée en direction de la couche intermédiaire.

Selon une autre particularité, la zone de travail déterminée est définie par un rectangle entourant en deux dimensions ledit ruban d'interconnexion.

Selon une autre particularité, la zone de travail comporte une troisième dimension, correspondant à la profondeur d'usinage.

### Brève description des figures

D'autres caractéristiques et avantages vont apparaître dans la description détaillée qui suit faite en regard des dessins annexés dans lesquels :
- Les figures 1A et 1B représentent, respectivement en perspective et en coupe transversale, la structure d'un module photovoltaïque ;
- La figure 1C illustre, par une vue en transparence, la structure de la couche intermédiaire du module photovoltaïque ;
- Les figures 2A et 2B illustrent le principe de réalisation de l'invention, selon deux modes de réalisation distincts ;

### Description détaillée d'au moins un mode de réalisation

Dans la suite de la description, la face avant du module photovoltaïque M correspond à une face du module recevant les rayons lumineux et la face arrière correspond à la face opposée à la face avant.

Dans la suite de la description, les termes arrière et avant sont donc à considérer en prenant un axe perpendiculaire à la surface du module et orientée de sa face arrière vers sa face avant.

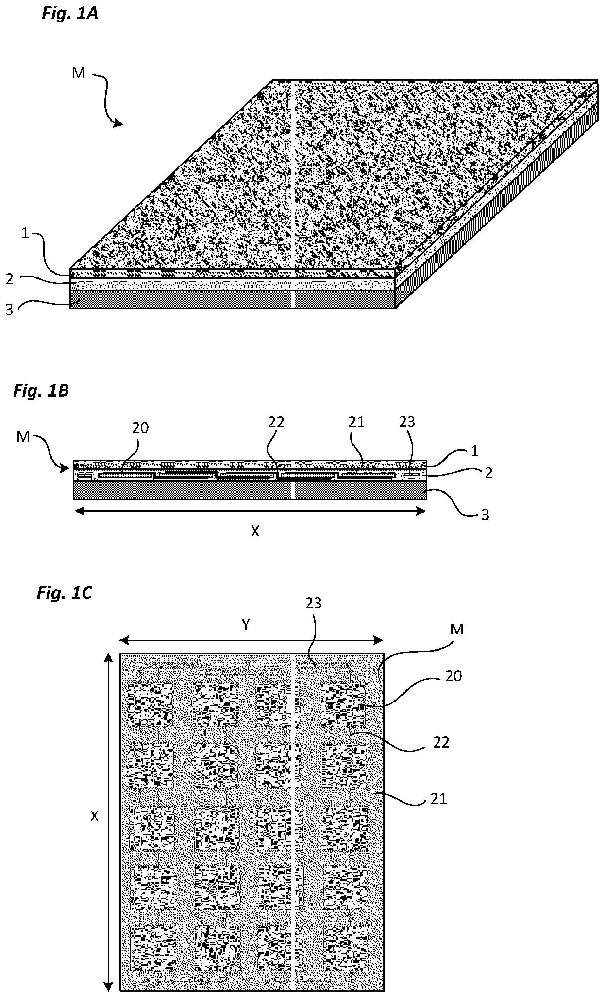

En référence à la figure 1A, à la figure 1B et à la figure 1C, de manière connue, un module photovoltaïque comporte plusieurs couches superposées et assemblées entre elles :
- Une première couche, dite couche arrière 1 (appelée couramment "backsheet"), formant un premier élément de protection en face arrière ; cette couche arrière est habituellement réalisée dans un matériau de type polymère à une ou plusieurs strates (voir ci-dessous) ;
- Une deuxième couche, dite couche intermédiaire 2, intercalée entre la couche arrière 1 et la couche avant 3 (décrite ci-dessous), permettant l'assemblage d'un côté de la couche arrière 1 et de l'autre côté de la couche avant 3 ; cette couche intermédiaire 2 comporte les cellules photovoltaïques 20, la connectique électrique 22 et une enveloppe d'encapsulation 21 arrangée autour des cellules photovoltaïques ;
- La couche avant 3, formant un deuxième élément de protection en face avant ; cette couche avant 3 est habituellement réalisée en verre ou dans un polymère transparent ;

Il faut noter que sur les figures annexées, le module photovoltaïque M est représenté retourné, de sorte que sa face arrière est située au-dessus et la face avant est située au-dessous.

Pour des soucis de lisibilité sur la figure 1A annexée, les différentes couches du module ne sont pas représentées à l'échelle. A titre d'exemple, la couche arrière 1 peut présenter une épaisseur de quelques centaines de µm (par exemple environ 350µm), la couche intermédiaire 2 peut présenter une épaisseur pouvant aller jusqu'à 1mm et la couche avant 3 peut présenter une épaisseur d'environ 3 à 4mm.

La couche arrière 1 peut notamment assurer une fonction d'imperméabilité aux gaz et à l'eau, une fonction de protection/isolation électrique et une fonction de protection mécanique.

Cette couche arrière 1 peut comporter une ou plusieurs strates distinctes (non représentées sur la figure 1A). Elle peut notamment comporter une première strate située le plus à l'arrière, réalisée à base d'un polymère fluoré, et une deuxième strate agencée devant cette première strate et composée d'un polymère non fluoré. Une troisième strate (non représentée) réalisée en polymère fluoré peut également être intégrée devant la deuxième strate, en contact avec la couche intermédiaire. Dans le cas où la couche arrière est composée d'une seule strate, celle-ci est composée d'un polymère non fluoré.

Le polymère fluoré peut être le polyfluorure de vinyle (PVF), par exemple commercialisé sous le nom TEDLAR (marque déposée) par la société DuPont (marque déposée).

Le polymère non fluoré peut être le PET (poly(téréphtalate) d'éthylène), le polyamide ou autre.

Dans la couche intermédiaire 2, l'enveloppe d'encapsulation 21 est classiquement réalisée dans un polymère tel que de l'EVA (Ethylène-Acétate de Vinyl) formant un matériau sur lequel peuvent adhérer la couche arrière 1 d'un côté et la couche avant 3 de l'autre côté et permettre l'assemblage des trois couches entre elles. Les trois couches peuvent être assemblées entre elles par laminage à chaud, de sorte que la couche arrière 1 et la couche avant 3 viennent adhérer au matériau de l'enveloppe d'encapsulation, formant ainsi un empilement monobloc.

En référence à la figure 1C, dans la couche intermédiaire 2, les cellules photovoltaïques 20 sont connectées entre elles, en série/parallèle, formant plusieurs chaînes ("string" en anglais) de cellules. Dans chaque chaîne, des éléments de connexion électrique permettent de relier les cellules photovoltaïques entre elles. En outre, des rubans d'interconnexion 23 électrique, par exemple en cuivre, permettent de connecter les chaines entre elles et d'assurer les liaisons électriques entre les chaînes de cellules photovoltaïques.

Pour la suite de la description, on considère que le module photovoltaïque a classiquement une forme rectangulaire, sa longueur X (suivant un axe dit longitudinal) étant orientée suivant la direction des chaînes de cellules photovoltaïques et sa largeur Y (suivant un axe dit transversal) suivant l'orientation des rubans d'interconnexion.

Le module photovoltaïque M peut comporter un cadre (non représenté), par exemple en aluminium, agencé en périphérie de l'empilement pour rigidifier le module M. Pour la mise en œuvre de l'invention décrite ci-dessous, ce cadre, ainsi que la boîte de jonction électrique (non représentée) généralement fixée sur la face arrière du module M, sont préalablement retirés. Le procédé de l'invention est en effet dédié plus particulièrement au traitement de l'empilement de couches du module photovoltaïque M.

Le principe de l'invention s'applique plus particulièrement au traitement de la couche intermédiaire 2 d'un module photovoltaïque M. Ce traitement s'inscrit dans un cadre plus global du démantèlement d'un module photovoltaïque, en vue de son recyclage.

Le traitement de la couche arrière 1 peut être réalisée préalablement selon différentes options. L'une des options peut consister à venir prélever un échantillon d'un module photovoltaïque en vue de le caractériser, pour en déduire les paramètres d'usinage à appliquer, ces paramètres d'usinage étant adaptés pour venir retirer la couche arrière 1 des modules photovoltaïques ayant une structure identique.

Avant d'effectuer le retrait par usinage et par exemple par ponçage, de la couche intermédiaire 2, l'invention consiste à venir retirer préalablement les rubans d'interconnexion 23, venant effectuer les connexions électriques entre les chaînes de cellules photovoltaïques. Comme illustré par la figure 1C, ces rubans d'interconnexion 23 sont souvent localisés en bord de modules, par exemple suivant deux bords opposés du module (suivant Y), en bout de chaîne.

Le procédé de l'invention est mis en œuvre à l'aide d'un système comportant une unité de traitement chargée de contrôler la mise en œuvre des différentes étapes du procédé. Le système peut également comporter :
- Un poste d'analyse chargé de localiser les rubans d'interconnexion 23 dans la couche intermédiaire 2 ;
- Au moins un poste d'usinage P_1, P_2 adapté à la mise en œuvre de l'invention ;

Le système peut comporter des moyens de convoyage, composés d'un ou plusieurs convoyeurs, contrôlés pour faire avancer le module photovoltaïque M lors de son traitement selon le principe de l'invention.

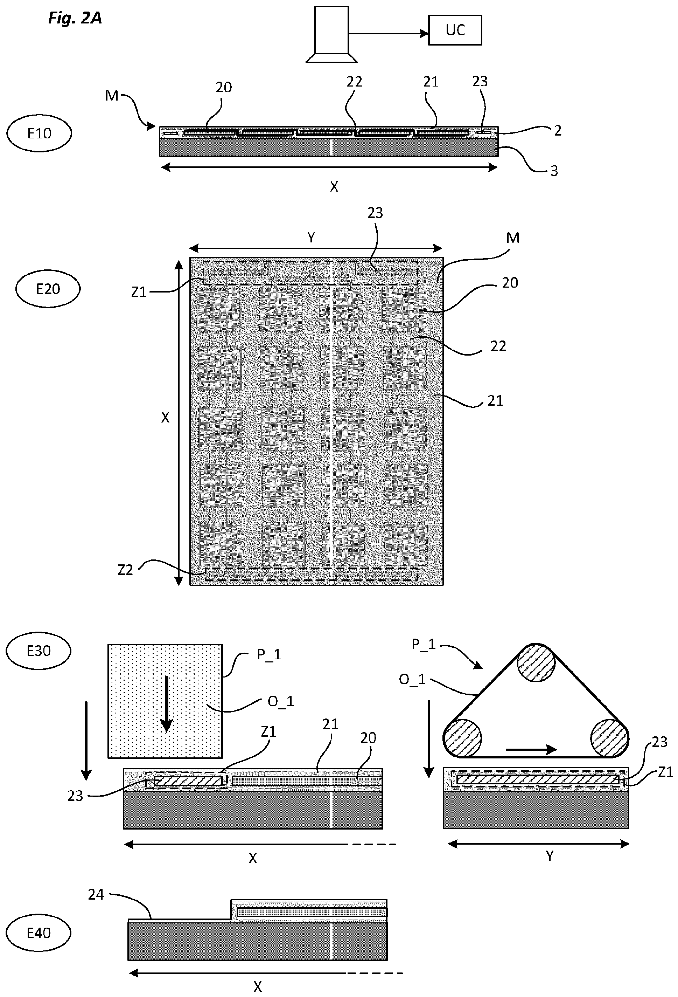

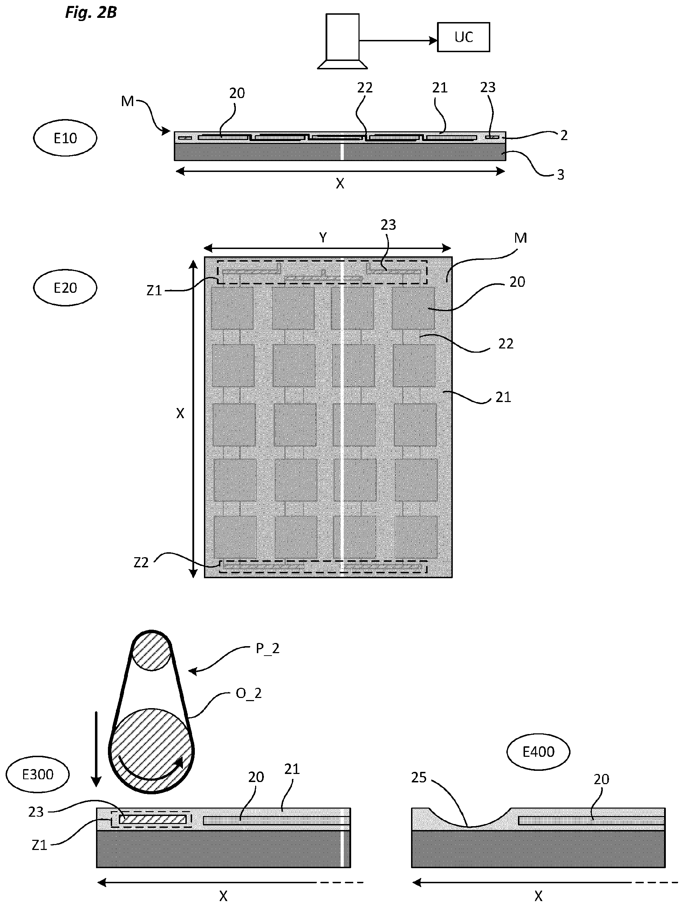

En référence à la figure 2A et à la figure 2B, le procédé de l'invention est décrit ci-dessous. Certaines étapes sont communes aux deux modes de réalisation. Les deux modes de réalisation diffèrent notamment entre eux par le principe d'usinage localisé de la couche intermédiaire 2 (étapes E30 et E300 sur les figures annexées).

Dans le cadre de l'invention, il faut considérer que le module photovoltaïque a subi un premier traitement dans lequel sa couche arrière 1 a déjà été retirée, par exemple par usinage. Le procédé de l'invention est adapté au traitement de la couche intermédiaire 2 du module photovoltaïque encore présente.

Une première étape E10 consiste à venir localiser les rubans d'interconnexion 23 présents dans la couche intermédiaire 2. Cette localisation peut être réalisée à l'aide de différents moyens de capture. Il peut s'agir de moyens de capture de type optique. Comme la couche arrière 1 a déjà été retirée, toutes les connexions électriques entre les cellules sont visibles par transparence. Comme décrit dans la demande de brevet WO2023/194155A1**,** un rétroéclairage peut également être employé pour obtenir une image plus contrastée.

De manière non limitative, l'analyse de la face arrière de la couche intermédiaire 2 du module photovoltaïque peut être réalisée :
- Par balayage optique à l'aide d'une sonde, afin de scanner toute la surface, ou
- Par acquisition à l'aide d'une caméra d'une seule ou plusieurs images de la surface du module photovoltaïque M.

L'unité de traitement est par exemple configurée pour localiser la présence des rubans d'interconnexion 23 à partir des données obtenues à l'aide des moyens de capture employés. L'unité de traitement peut ainsi analyser les données optiques acquises par la sonde ou les images capturées par la caméra. Toute autre solution de capture pourrait être employée.

Comme illustré par les figures 2A et 2B, cette étape de localisation E10 des rubans d'interconnexion est commune aux deux modes de réalisation.

Une fois les rubans d'interconnexion 23 localisés, dans une deuxième étape E20, l'unité de traitement est configurée pour définir une zone de travail Z1 sur laquelle un traitement par usinage va pouvoir être effectué.

Cette zone de travail Z1 est délimitée de manière à inclure au moins un ruban d'interconnexion 23 et d'exclure les cellules photovoltaïques 20. Cette zone de travail Z1 est définie sur la face arrière de la couche intermédiaire 2. Elle est par exemple de forme rectangulaire et correspond à la zone qui sera traitée par usinage en vue de venir retirer le ruban d'interconnexion 23, sans toucher aux cellules photovoltaïques (ni aux éléments de connexion reliant les cellules photovoltaïques). Cette zone de travail Z1 peut avantageusement inclure tous les rubans d'interconnexion 23 situés d'un seul côté du module. Si le module photovoltaïque intègre des rubans d'interconnexion longeant ses deux bords opposés, l'unité de traitement est configurée pour définir au moins deux zones de travail Z1, Z2 distinctes.

Une fois la zone de travail Z1 délimitée, l'unité de traitement enregistre les paramètres liés à cette zone.

De manière non limitative, compte tenu de l'agencement des rubans d'interconnexion 23, la zone de travail Z1 présente une forme allongée suivant la direction transversale. Elle peut être définie également en trois dimensions, en incluant la profondeur d'usinage. Il faut noter que la profondeur d'usinage de la couche intermédiaire 2 (correspondant à l'épaisseur de la couche intermédiaire lorsque la couche intermédiaire est usinée sur toute son épaisseur), peut être définie préalablement par tous moyens connus. La profondeur d'usinage est avantageusement choisie inférieure ou égale à l'épaisseur de la couche intermédiaire 2.

L'unité de traitement génère ensuite les paramètres d'usinage P_U à utiliser pour usiner ladite zone de travail Z1 délimitée (en longueur, en largeur et éventuellement en profondeur).

Selon le type d'usinage prévu, la taille de la zone de travail Z1 pourra différer. Comme illustré par les figures 2A et 2B, cette étape de détermination de chaque zone de travail est commune aux deux modes de réalisation.

Lors d'une troisième étape E30, E300, l'unité de traitement contrôle l'usinage de la zone de travail Z1, en respectant les paramètres d'usinage déterminés.

Selon une particularité, l'usinage de la zone de travail est avantageusement réalisé sans déplacement du module photovoltaïque M, ou éventuellement avec un faible mouvement de celui-ci (quelques centimètres par minute).

De manière avantageuse, l'usinage est mis en œuvre sur un poste d'usinage P_1, P_2 à l'aide d'un outil d'usinage O_1, O_2. L'outil d'usinage O_1, O_2 est avantageusement un outil de ponçage. Dans ce cas, une bande de ponçage est ainsi actionnée en mouvement contre la couche intermédiaire 2 du module photovoltaïque M de manière à venir retirer la matière. Pendant le ponçage, on récupère des copeaux et de la poudre, composés du matériau formant l'enveloppe d'encapsulation et de morceaux de rubans d'interconnexion 23.

Dans le premier mode de réalisation selon l'étape E30 (figure 2A), l'outil d'usinage O_1 est actionnée de manière transversale par rapport au plan défini par la face arrière de la couche intermédiaire 2 du module photovoltaïque. La bande de ponçage de cet outil d'usinage O_1 est mise en mouvement pour usiner la zone de travail Z1 suivant la direction de positionnement des rubans d'interconnexion (suivant Y).

La bande de ponçage présente avantageusement une largeur réduite de manière à ne pas venir usiner en dehors de la zone de travail Z1. Dans ce premier mode, la bande peut être arrangée de manière à venir usiner toute la zone de travail Z1, sur toute la largeur (Y) du module photovoltaïque M et sur une bande en longueur allant du bord du module jusqu'à une frontière marquant la limite entre la zone de travail Z1 et une zone incluant les cellules photovoltaïques 20.

A l'étape E40, on obtient ainsi le module photovoltaïque duquel a été retirée la couche arrière 1 et au moins une partie 24 de la couche intermédiaire 2, cette partie correspondant à celle intégrant initialement le ruban d'interconnexion 23. La couche intermédiaire 2 peut être usinée sur plusieurs zones de travail (voir ci-dessus) si des rubans d'interconnexion sont présents en divers endroits, notamment le long des deux bords opposés du module photovoltaïque M.

Dans le deuxième mode de réalisation selon l'étape E300 (figure 2B), l'outil d'usinage O_2 est également un outil de ponçage et le rouleau est orienté de sorte que son axe de rotation soit orienté parallèlement à ladite direction de positionnement (selon Y) des rubans d'interconnexion 23. Dans ce mode de réalisation, l'outil d'usinage O_2 vient ainsi usiner la zone de travail Z1 de manière localisée, en effectuant éventuellement plusieurs passes pour couvrir toute la largeur du module (selon Y), mais sur une bande étroite dans le sens de la longueur (selon X), de sorte que l'enveloppe d'encapsulation 21 reste présente de part et d'autre de cette bande étroite. Cet usinage localisé est notamment permis par le fait que le module photovoltaïque reste fixe. L'outil d'usinage O_2 est approché directement en vis-à-vis de la zone de travail Z1 suivant une direction normale à la face arrière de la couche intermédiaire. Le diamètre de l'outil de ponçage peut être choisi de manière à permettre le retrait de la couche intermédiaire sur la longueur (selon X) de la zone de travail Z1 en une seule passe.

A l'étape E400, on obtient ainsi le module photovoltaïque duquel a été retirée la couche arrière 1 et sur lequel une cavité 25 a été creusée dans la couche intermédiaire 2, cette cavité correspondant à la zone intégrant initialement le ruban d'interconnexion 23. La couche intermédiaire 2 peut également être usinée sur plusieurs zones de travail (voir ci-dessus) si des rubans d'interconnexion 23 sont présents en divers endroits, notamment le long des deux bords opposés du module photovoltaïque.

Une fois l'usinage de la zone de travail terminée, le retrait du reste de la couche intermédiaire 2 peut se poursuivre, par exemple par usinage (comme dans la demande de brevet EP4159397A1**)** ou une autre méthode.

Il faut noter qu'il serait possible de réaliser l'usinage de la zone de travail selon une autre technique. On peut travailler par enlèvement de matière en utilisant un ou plusieurs outils tranchants (fraisage, rabotage ou autre). Dans ce cas, plusieurs passes peuvent s'avérer nécessaires, en déplaçant le module photovoltaïque, éventuellement en faisant varier sa vitesse de déplacement lors de l'opération et/ou en inversant son sens de déplacement.

L'invention permet ainsi de réaliser un pré-usinage de la couche intermédiaire 2, afin de retirer les rubans d'interconnexion, susceptibles de perturber l'usinage du reste de la couche intermédiaire.

La solution de l'invention, selon le deuxième mode de réalisation permet un usinage sur une bande de matière étroite, ciblant directement la zone incluant les rubans d'interconnexion 23.

## Revendications

1. Procédé de traitement d'un module photovoltaïque (M), ledit module photovoltaïque comprenant une couche dite intermédiaire (2), cette couche intermédiaire comportant une enveloppe d'encapsulation (21) dans laquelle sont placées des cellules photovoltaïques (20) et au moins un ruban d'interconnexion (23), lesdites cellules photovoltaïques étant agencées en plusieurs chaînes, les chaînes étant connectées entre elles à l'aide dudit ruban d'interconnexion (23), ledit procédé étant **caractérisé en ce qu'**il comporte :
- Une étape de localisation du ruban d'interconnexion (23) à l'intérieur de la couche intermédiaire (2),
- Une étape de détermination d'une zone de travail (Z1) à usiner, ladite zone de travail (Z1) étant délimitée pour inclure le ruban d'interconnexion (23) et exclure toute cellule photovoltaïque (20),
- Une étape d'usinage localisée sur ladite zone de travail (Z1) uniquement.

2. Procédé selon la revendication 1, **caractérisé en ce que** l'étape d'usinage est mise en œuvre par ponçage.

3. Procédé selon la revendication 1 ou 2, **caractérisé en ce que** l'étape d'usinage est mise en œuvre en amenant un outil d'usinage (O_1, O_2) en vis-à-vis de la zone de travail déterminé suivant un axe perpendiculaire au plan défini par la surface de la couche intermédiaire (2).

4. Procédé selon la revendication 3, **caractérisé en ce que** l'outil d'usinage (O_1) est une bande de ponçage mise en mouvement autour d'un axe perpendiculaire à une direction (Y) suivant laquelle ledit ruban d'interconnexion (23) est déployé.

5. Procédé selon la revendication 3, **caractérisé en ce que** l'outil d'usinage (O_2) est une bande de ponçage mise en mouvement autour d'un axe parallèle à une direction (Y) suivant laquelle le ruban d'interconnexion (23) est déployé.

6. Procédé selon l'une des revendications 1 à 5, **caractérisé en ce que** l'étape de localisation du ruban d'interconnexion est mise en œuvre par capture optique de la couche intermédiaire (2).

7. Procédé selon l'une des revendications 1 à 5, **caractérisé en ce que** l'étape de localisation du ruban d'interconnexion est mise en œuvre par capture d'images à l'aide d'une caméra orientée en direction de la couche intermédiaire (2).

8. Procédé selon l'une des revendications 1 à 7, **caractérisé en ce que** la zone de travail (Z1) déterminée est définie par un rectangle entourant en deux dimensions ledit ruban d'interconnexion (23).

9. Procédé selon la revendication 8, **caractérisé en ce que** la zone de travail (Z1) comporte une troisième dimension, correspondant à la profondeur d'usinage.

10. Système de traitement d'un module photovoltaïque (M), ledit module photovoltaïque comprenant une couche dite intermédiaire (2), cette couche intermédiaire comportant une enveloppe d'encapsulation (21) dans laquelle sont placées des cellules photovoltaïques (20) et au moins un ruban d'interconnexion (23), lesdites cellules photovoltaïques étant agencées en plusieurs chaînes, les chaînes étant connectées entre elles à l'aide dudit ruban d'interconnexion (23), ledit système comportant une unité de traitement et des moyens d'analyse de la couche intermédiaire (2) configurés pour générer des données à destination de l'unité de traitement, **caractérisé en ce que**:
- L'unité de traitement est configurée pour localiser le ruban d'interconnexion (23) à l'intérieur de la couche intermédiaire (2) à partir des données reçues,
- L'unité de traitement est configurée pour déterminer une zone de travail (Z1) à usiner, ladite zone de travail (Z1) étant délimitée pour inclure le ruban d'interconnexion (23) et exclure toute cellule photovoltaïque (20),
- Le système comporte des moyens d'usinage contrôlés par l'unité de traitement pour usiner ladite zone de travail (Z1) uniquement.

11. Système selon la revendication 10, **caractérisé en ce que** les moyens d'usinage comportent un outil d'usinage (O_1, O_2) formé d'un outil de ponçage.

12. Système selon la revendication 10 ou 11, **caractérisé en ce que** les moyens d'usinage sont configurés pour amener un outil d'usinage (O_1, O_2) en vis-à-vis de la zone de travail déterminé suivant un axe perpendiculaire au plan défini par la surface de la couche intermédiaire (2).

13. Système selon la revendication 12, **caractérisé en ce que** l'outil d'usinage (O_1) est formé d'une bande de ponçage mise en mouvement autour d'un axe perpendiculaire à une direction (Y) suivant laquelle ledit ruban d'interconnexion (23) est déployé.

14. Système selon la revendication 12, **caractérisé en ce que** l'outil d'usinage (O_2) est formé d'une bande de ponçage mise en mouvement autour d'un axe parallèle à une direction (Y) suivant laquelle le ruban d'interconnexion (23) est déployé.

15. Système selon la revendication 15, **caractérisé en ce que** les moyens d'analyse comportent des moyens de capture optique de la couche intermédiaire (2).

16. Système selon la revendication 15, **caractérisé en ce que** les moyens d'analyse comportent des moyens de capture d'images à l'aide d'une caméra orientée en direction de la couche intermédiaire (2).

17. Système selon l'une des revendications 10 à 16, **caractérisé en ce que** la zone de travail (Z1) déterminée est définie par un rectangle entourant en deux dimensions ledit ruban d'interconnexion (23).

18. Système selon la revendication 17, **caractérisé en ce que** la zone de travail (Z1) comporte une troisième dimension, correspondant à la profondeur d'usinage.

## Patentansprüche

1. Verfahren zur Behandlung eines Photovoltaikmoduls (M), wobei das Photovoltaikmodul eine sogenannte Zwischenschicht (2) aufweist, wobei diese Zwischenschicht ein Kapselungsgehäuse (21) umfasst, in dem Photovoltaikzellen (20) und mindestens ein Zellverbinder (23) platziert sind, wobei die Photovoltaikzellen in mehreren Strings angeordnet sind, wobei die Strings untereinander mithilfe des Zellverbinders (23) verbunden sind, wobei das Verfahren **dadurch gekennzeichnet ist, dass** es umfasst:
- einen Schritt des Lokalisierens des Zellverbinders (23) im Inneren der Zwischenschicht (2),
- einen Schritt des Bestimmens eines zu bearbeitenden Arbeitsbereichs (Z1), wobei der Arbeitsbereich (Z1) so begrenzt ist, dass er den Zellverbinder (23) einschließt und jegliche Photovoltaikzelle (20) ausschließt,
- einen Schritt des Bearbeitens, der nur auf den Arbeitsbereich (Z1) lokalisiert ist.

2. Verfahren nach Anspruch 1, **dadurch gekennzeichnet, dass** der Schritt des Bearbeitens durch Schleifen durchgeführt wird.

3. Verfahren nach Anspruch 1 oder 2, **dadurch gekennzeichnet, dass** der Schritt des Bearbeitens durchgeführt wird, indem ein Bearbeitungswerkzeug (O_1, O_2) entlang einer Achse, die senkrecht zu der durch die Fläche der Zwischenschicht (2) definierten Ebene verläuft, gegenüber dem bestimmten Arbeitsbereich gebracht wird.

4. Verfahren nach Anspruch 3, **dadurch gekennzeichnet, dass** das Bearbeitungswerkzeug (O_1) ein Schleifband ist, das um eine Achse, die senkrecht zu einer Richtung (Y) verläuft, entlang welcher der Zellverbinder (23) eingesetzt ist, in Bewegung versetzt wird.

5. Verfahren nach Anspruch 3, **dadurch gekennzeichnet, dass** das Bearbeitungswerkzeug (O_2) ein Schleifband ist, das um eine Achse, die parallel zu einer Richtung (Y) verläuft, entlang welcher der Zellverbinder (23) eingesetzt ist, in Bewegung versetzt wird.

6. Verfahren nach einem der Ansprüche 1 bis 5, **dadurch gekennzeichnet, dass** der Schritt des Lokalisierens des Zellverbinders durch optisches Erfassen der Zwischenschicht (2) durchgeführt wird.

7. Verfahren nach einem der Ansprüche 1 bis 5, **dadurch gekennzeichnet, dass** der Schritt des Lokalisierens des Zellverbinders durch Erfassen von Bildern mithilfe einer in Richtung der Zwischenschicht (2) ausgerichteten Kamera durchgeführt wird.

8. Verfahren nach einem der Ansprüche 1 bis 7, **dadurch gekennzeichnet, dass** der bestimmte Arbeitsbereich (Z1) durch ein Rechteck definiert ist, das den Zellverbinder (23) in zwei Dimensionen umgibt.

9. Verfahren nach Anspruch 8, **dadurch gekennzeichnet, dass** der Arbeitsbereich (Z1) eine dritte Dimension aufweist, die der Bearbeitungstiefe entspricht.

10. System zur Behandlung eines Photovoltaikmoduls (M), wobei das Photovoltaikmodul eine sogenannte Zwischenschicht (2) aufweist, wobei diese Zwischenschicht ein Kapselungsgehäuse (21) umfasst, in dem Photovoltaikzellen (20) und mindestens ein Zellverbinder (23) platziert sind, wobei die Photovoltaikzellen in mehreren Strings angeordnet sind, wobei die Strings untereinander mithilfe des Zellverbinders (23) verbunden sind, wobei das System eine Behandlungseinheit und Analysemittel zur Analyse der Zwischenschicht (2), die dazu ausgestaltet sind, Daten für die Behandlungseinheit zu erzeugen, umfasst, **dadurch gekennzeichnet, dass**:
- die Behandlungseinheit dazu ausgestaltet ist, den Zellverbinder (23) ausgehend von den empfangenen Daten im Inneren der Zwischenschicht (2) zu lokalisieren;
- die Behandlungseinheit dazu ausgestaltet ist, einen zu bearbeitenden Arbeitsbereich (Z1) zu bestimmen, wobei der Arbeitsbereich (Z1) so begrenzt ist, dass er den Zellverbinder (23) einschließt und jegliche Photovoltaikzelle (20) ausschließt,
- das System Bearbeitungsmittel umfasst, die von der Behandlungseinheit gesteuert werden, um nur den Arbeitsbereich (Z1) zu bearbeiten.

11. System nach Anspruch 10, **dadurch gekennzeichnet, dass** die Bearbeitungsmittel ein Bearbeitungswerkzeug (O_1, O_2) umfassen, das aus einem Schleifwerkzeug gebildet wird.

12. System nach Anspruch 10 oder 11, **dadurch gekennzeichnet, dass** die Bearbeitungsmittel dazu ausgestaltet sind, ein Bearbeitungswerkzeug (O_1, O_2) entlang einer Achse, die senkrecht zu der durch die Fläche der Zwischenschicht (2) definierten Ebene verläuft, gegenüber dem bestimmten Arbeitsbereich zu bringen.

13. System nach Anspruch 12, **dadurch gekennzeichnet, dass** das Bearbeitungswerkzeug (O_1) aus einem Schleifband gebildet wird, das um eine Achse, die senkrecht zu einer Richtung (Y) verläuft, entlang welcher der Zellverbinder (23) eingesetzt ist, in Bewegung versetzt wird.

14. System nach Anspruch 12, **dadurch gekennzeichnet, dass** das Bearbeitungswerkzeug (O_2) aus einem Schleifband gebildet wird, das um eine Achse, die parallel zu einer Richtung (Y) verläuft, entlang welcher der Zellverbinder (23) eingesetzt ist, in Bewegung versetzt wird.

15. System nach Anspruch 15, **dadurch gekennzeichnet, dass** die Analysemittel Mittel zum optischen Erfassen der Zwischenschicht (2) umfassen.

16. System nach Anspruch 15, **dadurch gekennzeichnet, dass** die Analysemittel Mittel zum Erfassen von Bildern mithilfe einer in Richtung der Zwischenschicht (2) ausgerichteten Kamera umfassen.

17. System nach einem der Ansprüche 10 bis 16, **dadurch gekennzeichnet, dass** der bestimmte Arbeitsbereich (Z1) durch ein Rechteck definiert ist, das den Zellverbinder (23) in zwei Dimensionen umgibt.

18. System nach Anspruch 17, **dadurch gekennzeichnet, dass** der Arbeitsbereich (Z1) eine dritte Dimension aufweist, die der Bearbeitungstiefe entspricht.

## Claims

1. Method for processing a photovoltaic module (M), said photovoltaic module comprising what is referred to as an intermediate layer (2), this intermediate layer comprising an encapsulating envelope (21) in which photovoltaic cells (20) and at least one interconnect ribbon (23) are placed, said photovoltaic cells being arranged in several chains, the chains being connected to one another with the aid of said interconnect ribbon (23), said method being **characterized in that** it comprises:
- a step of locating the interconnect ribbon (23) inside the intermediate layer (2),
- a step of determining a working zone (Z1) to be machined, said working zone (Z1) being delimited so as to include the interconnect ribbon (23) and exclude any photovoltaic cell (20),
- a step of machining located only on said working zone (Z1).

2. Method according to Claim 1, **characterized in that** the machining step is implemented by sanding.

3. Method according to Claim 1 or 2, **characterized in that** the machining step is implemented by bringing a machining tool (O_1, O_2) opposite the determined working zone along an axis perpendicular to the plane defined by the surface of the intermediate layer (2).

4. Method according to Claim 3, **characterized in that** the machining tool (O_1) is a sanding belt moved about an axis perpendicular to a direction (Y) in which said interconnect ribbon (23) is deployed.

5. Method according to Claim 3, **characterized in that** the machining tool (O_2) is a sanding belt moved about an axis parallel to a direction (Y) in which the interconnect ribbon (23) is deployed.

6. Method according to any of Claims 1 to 5, **characterized in that** the step of locating the interconnect ribbon is implemented by optical capture of the intermediate layer (2).

7. Method according to any of Claims 1 to 5, **characterized in that** the step of locating the interconnect ribbon is implemented by capture of images with the aid of a camera oriented towards the intermediate layer (2).

8. Method according to any of Claims 1 to 7, **characterized in that** the determined working zone (Z1) is defined by a rectangle surrounding said interconnect ribbon (23) in two dimensions.

9. Method according to Claim 8, **characterized in that** the working zone (Z1) has a third dimension, corresponding to the machining depth.

10. System for processing a photovoltaic module (M), said photovoltaic module comprising what is referred to as an intermediate layer (2), this intermediate layer comprising an encapsulating envelope (21) in which photovoltaic cells (20) and at least one interconnect ribbon (23) are placed, said photovoltaic cells being arranged in several chains, the chains being connected to one another with the aid of said interconnect ribbon (23), said system comprising a processing unit and means for analyzing the intermediate layer (2) which are configured to generate data for the processing unit, **characterized in that**:
- the processing unit is configured to locate the interconnect ribbon (23) inside the intermediate layer (2) on the basis of the received data,
- the processing unit is configured to determine a working zone (Z1) to be machined, said working zone (Z1) being delimited so as to include the interconnect ribbon (23) and exclude any photovoltaic cell (20),
- the system comprises machining means controlled by the processing unit to machine only said working zone (Z1).

11. System according to Claim 10, **characterized in that** the machining means comprise a machining tool (O_1, O_2) formed by a sanding tool.

12. System according to Claim 10 or 11, **characterized in that** the machining means are configured to bring a machining tool (O_1, O_2) opposite the determined working zone along an axis perpendicular to the plane defined by the surface of the intermediate layer (2).

13. System according to Claim 12, **characterized in that** the machining tool (O_1) is formed by a sanding belt moved about an axis perpendicular to a direction (Y) in which said interconnect ribbon (23) is deployed.

14. System according to Claim 12, **characterized in that** the machining tool (O_2) is formed by a sanding belt moved about an axis parallel to a direction (Y) in which the interconnect ribbon (23) is deployed.

15. System according to Claim 15, **characterized in that** the analysis means comprise means for optically capturing the intermediate layer (2).

16. System according to Claim 15, **characterized in that** the analysis means comprise means for capturing images with the aid of a camera oriented towards the intermediate layer (2).

17. System according to any of Claims 10 to 16, **characterized in that** the determined working zone (Z1) is defined by a rectangle surrounding said interconnect ribbon (23) in two dimensions.

18. System according to Claim 17, **characterized in that** the working zone (Z1) has a third dimension, corresponding to the machining depth.
